# EUROPEAN PATENT APPLICATION

(11) **EP 2 320 717 A1**
(43) Date of publication of application: **11.05.2011**
(21) Application number: 10187867.6
(22) Date of filing: 18.10.2010
(51) Int. Cl.: H05K 1/09, H01B 1/02, H05K 3/24

(54) **Wiring circuit board and method of manufacturing the same**

(30) Priority: 20.10.2009 JP 2009241825
(71) Applicant: Nitto Denko Corporation, Ibaraki-shi Osaka 567-8680 (JP)
(72) Inventor: Ebe, Hiroshi, Osaka 567-8680 (JP)
(74) Representative: HOFFMANN EITLE

(57) **Abstract**

A wiring circuit board that suppresses the softening phenomenon of circuit interconnect lines with time and that maintains a high tensile strength over an extended period of time, and a method of manufacturing the same are provided. The circuit interconnect lines formed on an insulation layer for the wiring circuit board are made of a metal coating material having a metal composed principally of copper and containing 800 to 3000 ppm of bismuth.

## Description

### BACKGROUND OF THE INVENTION

### 1. Field of the Invention

The present invention relates to a wiring circuit board and a method of manufacturing the same. More particularly, the invention relates to a wiring circuit board useful as a flexible circuit board, and a method of manufacturing the same.

### 2. Description of the Related Art

A wiring circuit board configured such that a thin-film conductor circuit pattern serving as electrical interconnection is formed on an insulative film made of polyimide and the like is flexible, and has been widely used for a suspension board for a read/write head of a hard disk, a circuit board for a liquid crystal display, and the like. In recent years, as the size and weight of products become smaller and the density of recorded information becomes higher, the wiring circuit board tends to be required to form more interconnect lines in a limited area, that is, to achieve finer interconnect lines.

Examples of conventional methods of forming such interconnect lines include a subtractive process in which a polyimide varnish or the like is applied directly onto copper foil to form an insulation layer and a surface of the copper foil is partly etched, and an additive process in which interconnect lines are formed directly on an insulation layer by plating. For the requirement to achieve finer interconnect lines as described above, the additive process capable of freely designing the width and thickness of the interconnect lines has technological superiority. In the future, there is a likelihood that wiring circuit boards using the additive process will increase in number.

The formation of the interconnect lines using the additive process is done, for example, by applying current between a cathode that is an insulation layer formed with a seed layer for plating and an anode opposed to the cathode in an electrolytic solution. A solution containing copper ions, sulfate ions, trace amounts of chlorine, and organic additives is used as the electrolytic solution. Examples of the organic additives principally used include polymers such as polyethylene glycol, organosulfur compounds having a sulfone group such as bis (3-sulfopropyl) disulfide (SPS), and quaternary amine compounds such as Janus green B (JGB), as disclosed in PCT International Application No. 5-502062 (1993).

Wiring circuit boards are also required to make greater improvements than ever in characteristics of a metal material used for circuit interconnection. Examples of the required improvements include an improvement in flexibility with a decreasing bend radius, an improvement in tensile strength capable of withstanding the mounting of electronic components, and the like.

However, the plated interconnect lines produced by the method described earlier show a high tensile strength immediately after the plating process, but exhibit a softening phenomenon known as self annealing due to heat in the environment in which the plated interconnect lines are used or with the passage of time. The softening phenomenon is considered to arise from the enlargement or growth of crystal grains in a metal plated coating due to heat or with time. There is a danger that such a softening phenomenon gives rise to the reduction in durability and the like during the mounting of the electronic components.

### SUMMARY OF THE INVENTION

In view of the foregoing, it is therefore an object of the present invention to provide a wiring circuit board that suppresses the softening phenomenon of circuit interconnect lines due to heat or with time and that maintains a high tensile strength over an extended period of time, and a method of manufacturing the same.

To accomplish the above-mentioned object, a first aspect of the present invention is intended for a wiring circuit board comprising: an insulation layer; and a circuit interconnect line formed on the insulation layer and made of a metal coating material having a metal composed principally of copper and containing 800 to 3000 ppm of bismuth.

A second aspect of the present invention is intended for a method of manufacturing a wiring circuit board. The method comprises the step of forming a circuit interconnect line on an insulation layer by electroplating using an electrolytic solution including a metallic salt of a metal composed principally of copper, and a bismuth salt.

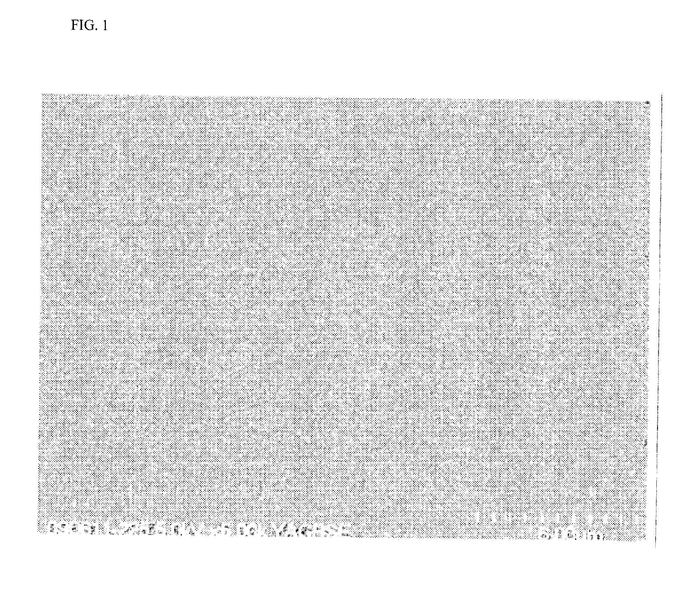

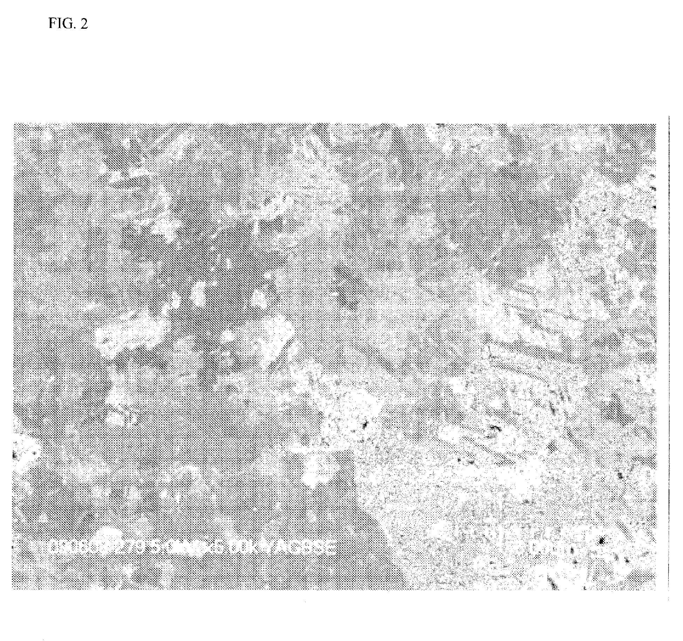

The present inventor has diligently studied how to solve the above-mentioned problems. As a result of the studies, the present inventor has found that the introduction of bismuth (Bi) within a specific range into metal, such as copper, that is a raw material of the metal coating material constituting the circuit interconnect line of the wiring circuit board, suppresses a softening phenomenon due to heat or with time to thereby achieve the production of the interconnect line capable of maintaining a high tensile strength over an extended period of time. The maintenance of such a high tensile strength is considered to result from a phenomenon that bismuth contained within the specific range suppresses the growth of crystal grains in a metal plated coating that forms the circuit interconnect lines to make the crystal grains finer (with reference to FIGS. 1 and 2) . FIG. 1 is a scanning electron microscope (SEM) micrograph (5000x) of copper plating foil having a bismuth content of approximately 870 ppm (a metal coating material constituting circuit interconnect lines in a wiring circuit board according to the present invention). FIG. 2 is a scanning electron microscope (SEM) micrograph (5000x) of copper plating foil free from bismuth (a metal coating material constituting circuit interconnect lines in a conventional wiring circuit board). It is observed that crystal grains in FIG. 1 are finer. Also, solute strengthening occurs due to the incorporation of bismuth into the metal, such as copper, which is the matrix of the metal plating. It is expected that such solute strengthening suppresses the enlargement or growth of crystal grains in the metal plated coating due to heat or with time to accordingly suppress the softening phenomenon.

As described above, the circuit interconnect lines formed on the insulation layer for the wiring circuit board according to the present invention are made of the metal coating material configured such that bismuth is contained with a specific range in metal, such as copper. Thus, the wiring circuit board suppresses the softening phenomenon of the circuit interconnect lines due to heat or with time, and maintains a high tensile strength over an extended period of time. This improves durability in the mounting of electronic components. The wiring circuit board according to the present invention is widely usable under circumstances where there is apprehension about the softening phenomenon because of the high-temperature environment in which the board is used, such as where a suspension board for a read/write head of a hard disk, and a circuit board for a liquid crystal display are used.

Preferably, a circuit interconnect coating made of the metal coating material has a tensile strength of not less than 700 MPa. This improves durability associated with the mounting of electronic components.

Preferably, the rate of change in tensile strength of the circuit interconnect coating made of the mental coating material after heat treatment for one hour at 200 °C is within 10%. This produces the excellent effect of suppressing the softening phenomenon due to heat or with time.

Preferably, the circuit interconnect coating is an electroplated coating. This advantageously provides desired physical properties according to the present invention.

Preferably, a circuit interconnect line for the wiring circuit board according to the present invention is formed by electroplating using an electrolytic solution including a metallic salt of a metal composed principally of copper, and a bismuth salt. This achieves the formation of the circuit interconnect line having desired physical properties with ease, and also achieves the formation of the interconnect line by an additive process, which in turn is capable of freely designing the width and thickness of the interconnect line, to thereby easily meet the requirement to make the wiring circuit board finer.

### BRIEF DESCRIPTION OF THE DRAWINGS

FIG. 1 is a scanning electron microscope (SEM) micrograph of a metal coating material (copper plating foil having a bismuth content of approximately 870 ppm) constituting circuit interconnect lines in a wiring circuit board according to the present invention.
FIG. 2 is a scanning electron microscope (SEM) micrograph of a metal coating material (copper plating foil free from bismuth) constituting circuit interconnect lines in a conventional wiring circuit board.

### DETAILED DESCRIPTION

A wiring circuit board according to the present invention includes an insulation layer, and circuit interconnect lines formed on the insulation layer and made of a metal coating material having a metal composed principally of copper and containing 800 to 3000 ppm of bismuth. The term "metal composed principally of copper" used herein refers to copper itself or an alloy containing at least 99.99% by weight of copper, and examples of the other alloy material include nickel, tin, zinc, and iron.

The metal constituting the metal coating material is required to have a bismuth content in the range of 800 to 3000 ppm, as described above. When the bismuth content is lower than the aforementioned range, the effect of suppressing the softening phenomenon due to heat or with time is not sufficiently produced. On the other hand, when the bismuth content is higher than the aforementioned range, there arises a trouble such that the coating becomes too brittle to be formed as a film. The bismuth content in the metal is measured, for example, by preparing the metal coating as a sample, adding a piece of the sample to a concentrated nitric acid solution contained in a vessel, hermetically sealing the vessel, irradiating the resultant solution in the vessel with microwaves to cause pressure acid decomposition at a maximum temperature of 230°C , thereafter adding ultrapure water to the solution, and analyzing the resultant solution with an inductively coupled plasma mass spectroscope (ICP-MS).

Preferably, a circuit interconnect coating made of the metal coating material has a thickness in the range of 1 to 35 *µ*m from the viewpoint of flexibility and the like.

The circuit interconnect coating preferably has a tensile strength of not less than 700 MPa, more preferably in the range of 700 to 800 MPa. The circuit interconnect coating having a tensile strength falling in such a range is excellent in durability associated with the mounting of electronic components. The rate of change in tensile strength of the circuit interconnect coating after heat treatment for one hour at 200°C is preferably within 10%. The rate of change in tensile strength falling within such a range is useful for suppressing the softening phenomenon due to heat or with time. The tensile strength is measured, for example, by putting a sample prepared by machining the metal foil to a predetermined size into a tensile testing apparatus (TECHNOGRAPH available from Minebea Co., Ltu. ) .

The circuit interconnect coating is preferably an electroplated coating from the viewpoint of advantageously obtaining desired physical properties according to the present invention.

In some cases, the circuit interconnect coating contains, for example, trace elements coming from a plating solution, such as sulfur (S) and chlorine (Cl) in addition to bismuth.

Examples of the material of the insulation layer corresponding to a surface for the formation of the circuit interconnect coating include synthetic resins such as polyimide, polyamide imide, acrylic, polyether nitrile, polyether sulfone, polyethylene terephthalate, polyethylene naphthalate, and polyvinyl chloride. Of these, polyimide is preferably used as the material of the insulation layer from the viewpoint of flexibility. The term "insulation layer" is to be interpreted as including, for example, a substrate itself such as a resin substrate and a film substrate in addition to the insulation layer formed on a substrate such as a metal substrate.

The circuit interconnect lines are formed on one or both of the opposite surfaces of the insulation layer. The circuit interconnect lines are formed, for example, by a patterning process such as an additive process and a subtractive process, preferably by an additive process. This is because the additive process is capable of freely designing the width and thickness of the circuit interconnect lines to thereby easily meet the requirement to make the wiring circuit board finer.

The additive process is performed in a manner described below. First, a metal thin film serving as a seed film is formed over the entire surface of the insulation layer by a thin film formation process such as a sputtering process using copper, chromium, nickel, and their alloys. Next, a plating resist having a pattern that is the reverse of the pattern of the circuit interconnect lines is formed on a surface of the metal thin film. The plating resist is formed by the processes of exposure to light and development of a dry film photoresist and the like. Thereafter, electroplating in the circuit interconnect line pattern is done on the surface of the metal thin film uncovered by the plating resist by using an electrolytic solution having a special electrolytic solution composition. Thereafter, the plating resist is removed by etching or stripping. The metal thin film uncovered by the circuit interconnect line pattern is removed by etching. This provides intended circuit interconnect lines on the insulation layer.

The electrolytic solution composition of the electrolytic solution includes a metallic salt of a metal composed principally of copper, and a bismuth salt. Since bismuth and copper are close in deposition potential to each other, there is no need for the operation of making the deposition potentials of bismuth and copper closer to each other, e.g. the addition of a complexing agent and the like, but there is an advantage in that the conventional electrolytic solution composition may be used as it is. A preferable example of the metallic salt serving as a source of copper ions in the electrolytic solution includes copper sulfate because it is excellent in shine and in leveling function. A preferable example of the bismuth salt serving as a source of bismuth ions includes bismuth sulfate which does not significantly destroy the electrolytic solution composition. To the electrolytic solution may be added common organic additives for the electrolytic solution composition, sulfuric acid, and chlorine, as required. Examples of the common organic additives include polymers such as polyethylene glycol, organosulfur compounds having a sulfone group such as bis (3-sulfopropyl) disulfide (SPS) , and quaternary amine compounds such as Janus green B (JGB) . Preferable examples of the electrolytic solution composition according to the present invention and their proportions are listed in Table 1 below.

**TABLE 1**

| Electrolytic Solution Compositions | |
|---|---|
| Copper Sulfate [CuSO₄·5H₂O] | 80-370 g/l |
| Sulfuric Acid [H₂SO₄] | 80-250 g/l |
| Chlorine Ions [C1⁻] | 5-80 mg/l |
| Organic Additives | 0.1-10 ml/l |
| Bismuth Sulfate [Bi₂(SO₄)₃] | 2-9 g/l |

The circuit interconnect lines may be formed by the subtractive process, as mentioned above. The subtractive process is performed in a manner described below. First, metal foil made of a metal coating material having a metal composed principally of copper and containing 800 to 3000 ppmof bismuth is formed in a stacked manner over the entire surface of the insulation layer, with an adhesive layer therebetween, as required. Then, an etching resist is formed in the same pattern as the pattern of the circuit interconnect lines on a surface of the metal foil formed in a stacked manner on the insulation layer. The etching resist is formed by using a dry film photoresist and the like. Thereafter, the metal foil uncovered by the etching resist is etched. Then, the etching resist is removed by etching or stripping. This provides intended circuit interconnect lines on the insulation layer.

In the wiring circuit board according to the present invention, a surface protection layer (or a cover insulation layer) may be provided, as required, on the circuit interconnect lines. The surface protection layer is, for example, formed from a cover-lay film made of the same material (polyimide and the like) as the insulation layer as mentioned earlier or formed of an epoxy solder resist, an acrylic solder resist, a urethane solder resist, and other solder resists.

The wiring circuit board according to the present invention thus obtained, which hardly exhibits the softening phenomenon of the circuit interconnect lines due to heat or with time and which maintains a high tensile strength over an extended period of time, is useful as a board for various electronic devices. In particular, the wiring circuit board according to the present invention is advantageously used as a suspension board for a read/write head of a hard disk, a circuit board for a liquid crystal display, and the like.

Next, inventive examples of the present invention will be described. It should be noted that the present invention is not limited to the inventive examples.

### EXAMPLES

### Inventive Examples 1-6 and Comparative Examples 1-7

Copper sulfate [CuSO_{4.}5H₂O] (available from Nippon Mining & Metals Co., Ltd.), sulfuric acid [H₂SO_{4]} (available from Wako Pure Chemical Industries, Ltd.), chlorine (available from Wako Pure Chemical Industries, Ltd.), an organic additive (CC-1220 available from Electroplating Engineers of Japan Ltd.), and bismuth sulfate [Bi₂(SO₄)₃] (available from Wako Pure Chemical Industries, Ltd.) were prepared and mixed together in predetermined proportions to prepare an electrolytic solution. Using the electrolytic solution, a stainless steel plate as a cathode, and a copper plate as an anode, plating was performed on the stainless steel plate under conditions of an electrolytic solution temperature of 25°C and a current density of 3 A / dm² to attain a thickness of 20 *µ*m. During the plating, the electrolytic solution was agitated by bubbling.

The electrolytic solution was prepared so that concentration proportions were 70 g/l of CuSO_{4˙5}H₂O, 180 9/1 of H₂SO₄, 40 mg/l of the chlorine ions (Cl⁻) , and 3 ml/l of the organic additive. The bismuth sulfate was added in concentration proportions shown in Tables 2 and 3 to the electrolytic solution in Inventive Examples and Comparative Examples.

The content of bismuth (Bi) in plating foil in Inventive Examples and Comparative Examples that was formed using the electrolytic solution in which the concentration of the bismuth sulfate was thus adjusted was analyzed in a manner to be described below. The plating foil formed on the stainless steel plate as mentioned above was prepared as a sample. A piece of the sample of approximately 5 mg was added to 5 ml of a concentrated nitric acid solution contained in a vessel, and the vessel was hermetically sealed. The resultant solution in the vessel was irradiated with microwaves to cause pressure acid decomposition at a maximum temperature of 230°C. After the decomposition, ultrapure water was added to the solution until the volume was fixed at 25 ml. Thereafter, the bismuth content in the foil was analyzed with an inductively coupled plasma mass spectroscope (ICP-MS) (7500csavailable from Agilent Technologies). The results of the analysis were listed in Tables 2 and 3 below.

**TABLE 2**

| | Inventive Examples | | | | | |
|---|---|---|---|---|---|---|
| | 1 | 2 | 3 | 4 | 5 | 6 |
| Concentration of Bismuth Sulfate in Electrolytic Solution (g/l) | 1.5 | 2.0 | 2.5 | 3.0 | 3.5 | 8.0 |
| Content of Bismuth in Foil (ppm) | 800 | 820 | 970 | 1250 | 1500 | 3000 |

**TABLE 3**

| | Comparative Examples | | | | | | |
|---|---|---|---|---|---|---|---|
| | 1 | 2 | 3 | 4 | 5 | 6 | 7 |
| Concentration of Bismuth Sulfate in Electrolytic Solution (g/l) | 0 | 0.8 8 | 1.0 0 | 1.4 4 | 1.6 | 1.8 | 8.5 |
| Content of Bismuth in Foil (ppm) | 0 | 300 | 460 | 565 | 730 | 780 | 3200 |

Then, tensile strength measurement and evaluation in the early stage and after a certain elapsed time were made on the plating foil in Inventive Examples and Comparative Examples that exhibited the bismuth (Bi) content shown in Tables 2 and 3 in a manner to be described below.

Plating foil were prepared within one day of the plating process (early-stage plating foil), and plating foil provided by making an alternative accelerated test for the measurement of changes with time, i.e., by heat-treating the early-stage plating foil at 200°C for 50 minutes (heat-treated plating foil) both of which were produced based on the above-mentioned method. The early-stage plating foil and the heat-treated plating foil were cut to a size of 3 mm by 90 mm to produce samples. The tensile strengths of the respective samples of the early-stage plating foil and the heat-treated plating foil were measured with a tensile testing apparatus (TECHNOGRAPH available from Ninebea Co., Ltd.) under conditions of a chuck-to-chuck distance of 2 cm and a tension speed of 5 mm/min . The results of the measurement were listed in Tables 4 and 5 below. The samples of the early-stage plating foil and the heat-treated plating foil according to the present invention were required to have a tensile strength of not less than 700 MPa. In Tables 4 and 5,the samples that satisfied this requirement were evaluated as being "good" and indicated by open circles, and the samples that did not satisfy this requirement were evaluated as being "unacceptable" and indicated by crosses.

**TABLE 4**

| | | Inventive Examples | | | | | |
|---|---|---|---|---|---|---|---|
| | | 1 | 2 | 3 | 4 | 5 | 6 |
| Tensile Strength (MPa) | arly-stage | 744 | 759 | 788 | 800 | 778 | 810 |
| | Evaluation | O | O | O | O | O | O |
| | Heat-Treated | 721 | 797 | 755 | 788 | 759 | 804 |
| | Evaluation | O | O | O | O | O | O |

**TABLE 5**

| | | Comparative Examples | | | | | | |
|---|---|---|---|---|---|---|---|---|
| | | 1 | 2 | 3 | 4 | 5 | 6 | 7 |
| Tensile Strength (MPa) (Mpa) | Early-stage 376 | 376 | 341 | 401 | 784 | 774 | 800 | - |
| | Evaluation | X | X | X | O | O | O | X |
| | Heat-Heat-Treated | 348 | 307 | 351 | 419 | 460 | 456 | - |
| | Evaluation | X | X | X | X | X | X | X |

These results showed that the products of the Inventive Examples having a bismuth content falling within a specific range had steady tensile strengths not only in the early stage but also after the heat treatment to attain high tensile strengths. This enables the wiring circuit board according to the present invention including circuit interconnect lines made of a metal coating material similar to that of the plating foil of Inventive Examples to suppress the softening phenomenon of the circuit interconnect lines due to heat or with time and to maintain a high tensile strength over an extended period of time. Therefore, the wiring circuit board according to the present invention including the circuit interconnect lines made of the metal coating material similar to that of the plating foil of Inventive Examples is widely usable under circumstances where there is apprehension about the softening phenomenon because of the high-temperature environment in which the board is used, just as a suspension board for a read/write head of a hard disk, and a circuit board for a liquid crystal display are used.

In Comparative Examples 1 to 3, on the other hand, bismuth was not present or the bismuth content was too low, so that the high tensile strength was not attained even in the early stage. In Comparative Examples 4 to 6, a high tensile strength was attained in the early stage. However, the bismuth content falls below the range specified according to the present invention, and the tensile strength is decreased by heat treatment. For this reason, it is considered difficult for Comparative Examples 4 to 6 to suppress the softening phenomenon over an extended period of time. In Comparative Example 7, the bismuth content was so high that the foil fell off during the plating process. The difficulties in film deposition made the measurement of the tensile strength impossible in Comparative Example 7. It should be noted that the bismuth content in the foil in Comparative Example 7 in Table 3 is the measured content of bismuth (Bi) in the foil that fell off.

It has been experimentally confirmed that the circuit interconnect lines for the wiring circuit board according to the present invention may be formed by electroplating using an electrolytic solution as used in Inventive Examples, whereby the circuit interconnect lines having desired physical properties are formed with ease, and that the circuit interconnect lines may be formed by the additive process, which in turn is capable of freely designing the width and thickness of the interconnect lines, to thereby easily meet the requirement to make the wiring circuit board finer.

Although a specific form of embodiment of the instant invention has been described above and illustrated in the accompanying drawings in order to be more clearly understood, the above description is made by way of example and not as a limitation to the scope of the instant invention. It is contemplated that various modifications apparent to one of ordinary skill in the art could be made without departing from the scope of the invention.

## Claims

1. A wiring circuit board comprising:
(i) an insulation layer and formed thereon
(ii) a circuit interconnect line formed on the insulation layer and made of a metal coating material having a metal composed principally of copper and containing 800-3,000 ppm of bismuth.

2. The wiring circuit board of claim 1, wherein a circuit interconnect coating made of the metal coating material has a tensile strength of not less than 700 MPa.

3. The wiring circuit board of claim 1 or 2, wherein the rate of change in tensile strength of the circuit interconnect coating made of the metal coating material after heat treatment for one hour at 200°C is within 10%.

4. The wiring circuit board of any of claims 1-3, wherein the circuit interconnect coating is an electroplated coating.

5. The wiring circuit board of any of claims 1-4, the wiring circuit board is a suspension board for a read/write head of a hard disk or a circuit board for a liquid crystal display.

6. A method of manufacturing a wiring circuit board, comprising the step of forming a circuit interconnect line on an insulation layer by electroplating using an electrolytic solution including a metallic salt of a metal composed principally of copper, and a bismuth salt.

7. The method of claim 6, which is a method of manufacturing the wiring circuit board as defined on any of claims 1-5.
